# EUROPEAN PATENT SPECIFICATION

(11) **EP 0 451 254 B1**
(45) Date of publication and mention of the grant of the patent: **20.12.1995**
(21) Application number: 90916869.2
(22) Date of filing: 29.10.1990
(51) Int. Cl.: H05K 3/46

(54) **MULTILAYER CIRCUIT BOARD HAVING MICROPOROUS LAYERS AND PROCESS FOR MAKING SAME**
MEHRSCHICHTLEITERPLATTE MIT MIKROPORÖSEN SCHICHTEN UND VERFAHREN ZUR HERSTELLUNG
CARTE DE CIRCUITS MULTICOUCHES A COUCHES MICROPOREUSES ET SON PROCEDE DE FABRICATION

(30) Priority: 30.10.1989 US 429139
(43) Date of publication of application: 16.10.1991
(73) Proprietor: THE FOXBORO COMPANY, Foxboro, MA 02035 (US)
(72) Inventor: GRANDMONT, Paul, E., Cumberland, RI 02864 (US); LAKE, Harold, Sharon, MA 02067 (US); ANDERSON, Richard, A., North Attleboro, MA 02760 (US)
(74) Representative: Dempster, Benjamin John Naftel
(86) International application number: US9006273
(87) International publication number: WO9106423

(56) References cited:
- EP-A- 0 259 812
- EP-A- 0 270 945
- EP-A- 0 273 374
- WO-A-88/04877
- US-A- 4 283 243
- US-A- 4 666 818

## Description

### Background of the Invention

This invention relates to manufacturing printed wiring boards.

Printed wiring boards (PWB) perform several indispensable functions in electronic devices of all kinds. First, individual electrical components, e.g., specially packaged integrated circuits, resistors, etc., are mounted or carried on the surface of the flat, usually sturdy, card-like board. Thus, the PWB serves as a unitary mechanical support for the components. Secondly, using chemically etched or plated conductor patterns on the board's surface, the PWB forms the desired electrical connections between the components. Furthermore, the PWB often includes metal areas serving as heat sinks for high power or thermally sensitive components.

As the use of integrated circuits has grown, the higher density of connections between components has necessitated double-sided PWB's in which additional interconnections are made employing conductor patterns on the other side of the board. This trend has been extended to boards having many layers of interconnections called multilayer PWB's. Connections from layer to layer are typically made by plated-through holes.

Conductor patterns can be formed using either subtractive or additive processes. In a typical subtractive process, a photoresist layer is applied to the copper foil portion of a copper foil-clad epoxy fiberglass substrate and patterned by exposure to ultraviolet light through a stencil-like film artwork mask. The exposed areas of the photoresist are polymerized. The unexposed, unpolymerized areas are removed by a chemical developing solution, leaving areas of copper having the desired conductor pattern underneath the protective barrier of the remaining polymerized photoresist. The exposed copper is then electroplated or etched away (i.e. "subtracted") and the remaining photoresist removed to expose the conductor pattern.

An additive process for forming the conductor pattern starts with an insulating substrate, typically a plastic laminate, throughout which is dispersed a catalyst capable of initiating metal plating on the substrate; typical catalysts are palladium-based materials. The catalytic substrate, referred to as a "fully additive base material," is coated with photoresist and the photoresist is patterned as described above. The holes through the resist formed when the unpolymerized resist is washed away are then filled with metal using electroless plating techniques. Since the conductors are produced by the addition of metal, rather than subtraction as in etching, the process is called "additive".

To promote adhesion between the plated metal and the substrate, the substrate typically is coated with a catalytic adhesive prior to application of the photoresist. The adhesive is usually a resin blend containing the plating catalyst and a colloidal suspension of rubber. The adhesive is treated with a strong etchant which primarily attacks the rubber component, etching it almost entirely. This treatment creates catalytic micropores in the adhesive that promote adhesion between the plated metal and the substrate surface.

In addition to the full additive base material described above, semi-additive base materials, which are also adhesive-coated, can be used as the substrate material. Both the semi-additive material and its adhesive lack the dispersed catalyst. They are rendered microporous as described above and then immersed in a solution containing a precursor for the catalyst. The precursor is subsequently activated to expose catalytic sites for the plating operation.

EP-A-0273374 discloses a printed wiring board comprising a circuit layer made of copper and an adjacent via layer of a photopolymerizable composition. Microporous receptor particles of gamma-aluminium oxide, Boehmite alumina, silica or magnesium dioxide are applied to the via layer to obtain microporosity.

According to one aspect of the invention there is provided a printed wiring board comprising a circuit layer made of a first material and a via layer adjacent the circuit layer and made of a second material different from the first material, characterised in that the via layer is made of a cured microporous photopolymer.

In preferred embodiments, the via layer includes a cured microporous photopolymer which is preferably moderately hydrophilic (with a wetting tension of at least 52 dynes/cm), e.g., the polymerized product of an ethylenically unsaturated monomer, a polymerization initiator activatable by actinic radiation, at least one preformed, water-soluble, polymeric binder, and a particulate organic filler transparent to actinic radiation in which the filler particles are chemically bonded to the binder. The micropores are preferably fractal micropores.

Another preferred via layer includes two layers of a cured microporous photopolymer separated by a layer of woven fabric. The woven fabric preferably is capable of bonding to the photopolymer and has a refractive index that substantially matches the refractive index of the photopolymer. The thickness of the upper layer of the photopolymer preferably is less than the diameter of the micropores.

The circuit layer of the printed wiring board preferably includes a cured moderately hydrophobic photopolymer whose wetting tension is less than 40 dynes/cm. The preferred photopolymer includes the polymerized product of a monomer which is a half acryloyl ester of bisphenol A epoxy monomer, a polymerization initiator activatable by actinic radiation, and at least one preformed elastomeric polymeric binder that is substantially free of acidic groups. The photopolymer preferably contains an acrylated urethane as well.

According to another aspect of the invention there is provided a process for preparing a printed wiring board comprising the steps of
forming a microporous via layer from a photoprocessable photopolymer by creating micropores in the photoprocessable photopolymer;
forming a circuit layer on the via layer; and
contacting the via and circuit layers with a metal plating solution, thereby depositing metal on the portions of the via layer, excluding the circuit layer, exposed to the plating solution.

In preferred embodiments, the via layer is mass-seeded with catalyst particles capable of initiating metal plating prior to formation of the circuit layer or selectively seeded with the catalyst particles subsequent to formation of the circuit layer. Where the photoprocessable material forming the via layer contains filler particles, seeding may be accomplished by coating the filler particles with catalyst prior to formation of the micropores.

One preferred way of forming the micropores in the via layer involves overlaying the photoprocessable material with a mask having a plurality of dots, the diameter of the dots being selected to create micropores having a predetermined diameter; exposing the photoprocessable material through the mask to a source of radiation; and developing the exposed areas of the photoprocessable material to create the micropores. The dots preferably have diameters between 5 and 30 micrometres and centers between 12 and 60 micrometres. The mask preferably further includes a via pattern whereupon the exposure and development steps simultaneously create vias and micropores in the photoprocessable material.

A second preferred method for forming the micropores involves preparing a digital representation of a pattern that includes a plurality of dots, the diameter of said dots being selected to create micropores having a predetermined diameter; applying a layer of unexposed, undeveloped photographic imaging film to the photoprocessable material that is sensitive to a different spectrum of energy from the photoprocessable material or is differentially sensitive to the same spectrum of energy; selectively exposing the film with an automatic photoplotter controlled by the digital representation to activate the film without affecting the underlying layer of photoprocessable material; developing the film; exposing the photoprocessable material through the image developed in the film as an in situ mask; and developing the exposed areas of the photoprocessable material to create the micropores. As described above, the diameter of each dot preferably is about 5 micrometres. The pattern preferably further includes a via pattern so that the imaging and development steps simultaneously create vias and micropores in the photoprocessable material.

In other preferred embodiments, the via layer is treated with a reactive coupling agent to chemically bond the agent to the surface of the via layer. Examples of preferred coupling agents include organotitanates, organozirconates, and organosilanes, used alone or in combination with each other. Preferably, the coupling agent is capable of catalyzing the deposition of metal on the exposed portions of the via layer.

The method may be an electroless plating process that includes contacting a catalytically activated layer of a microporous photoprocessable material deposited on a substrate with a metal plating solution under reaction conditions sufficient to deposit metal on the portions of the layer exposed to the plating solution.

In one preferred embodiment, the catalytically activated layer is prepared by creating micropores in a layer of photoprocessable material deposited on a substrate; curing the layer; and then seeding the layer with a catalyst capable of initiating metal plating. In another preferred embodiment, the catalytically activated layer is prepared by incorporating a catalyst in a photoprocessable material and then creating micropores in the material. Preferred photoprocessable materials and methods for creating the micropores are as described above.

The method may be an electroless plating process that includes the steps of treating the surface of a photoprocessable material with a reactive coupling agent to chemically bond the photoprocessable material to the coupling agent; and treating the photoprocessable material with a metal plating solution under reaction conditions sufficient to deposit metal on the portions of the photoprocessable material exposed to the plating solution. Preferred coupling agents are as described above.

The invention provides printed wiring boards in which metal plating adheres tenaciously and selectively to the via layers and not in the circuit layer surfaces. The use of a microporous photoprocessable material in the via layers makes board manufacture simple and safe by allowing metal to be plated directly onto the material and by avoiding the need for special adhesives that must be treated with strong, toxic, environmentally hazardous etchants. Furthermore, multilayer boards can be fabricated because the problems of plating bath contamination and etching of already plated metal associated with the use of strong etchants are avoided. Devices made of the microporous material are lightweight and efficient.

Other advantages of the invention will be apparent from the following description of the preferred embodiments thereof, and from the claims.

### Description of the Preferred Embodiments

We first briefly describe the drawings.

Fig. 1 is a diagrammatic cross-sectional view of the sequential construction of a multilayer printed wiring board fabricated using mass seeding.

Fig. 2 is a cross-sectional view of a fractal micropore.

Fig. 3 is a diagrammatic cross-sectional view of the sequential construction of a multilayer printed wiring board fabricated using selective seeding.

Fig. 4 is a cross-sectional view of a microporous material having a woven mesh interposed between two layers of photoprocessable material.

### Detailed Description

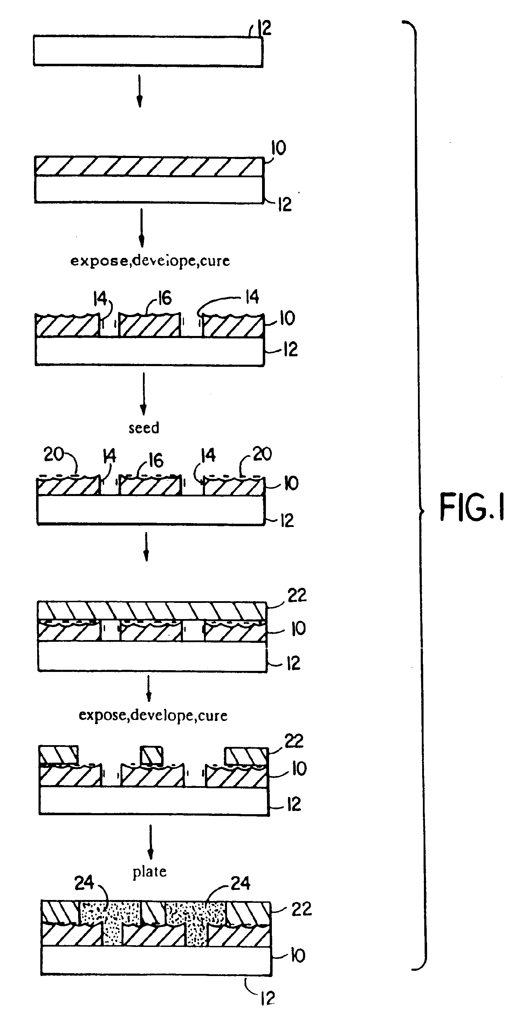

Referring to Fig. 1, the first step in constructing a representative single-sided printed wiring board (PWB) using mass seeding is to hot-roller laminate a layer 10 of photoprocessable material approximately 38.1 micrometres (0.0015 inch) thick on a copper plate 12 approximately 1.57 micrometres (0.062 inch) thick. The preferred photoprocessable material is an aqueous-processable, moderately hydrophilic, dry film photopolymerizable composition as disclosed in Tecle et al., European Patent Application No. 87113013.4 published March 16, 1988 as EP-A-0 259 812. This composition consists of an ethylenically unsaturated monomer, an initiator activatable by actinic radiation, at least one preformed, water-soluble, polymeric binder, and particles of an inorganic material transparent to actinic radiation which are chemically bonded to the binder. It has a wetting tension of at least 52 dynes/cm (e.g., 52-56 dynes/cm) as measured according to ASTM D2578-67. The wetting tension is an indication of the hydrophilicity/hydrophobicity of the material; the higher the wetting tension the more hydrophilic the material is.

As disclosed in Tecle et al., preferred fillers are silica, silicate, alumina, or carbonate particles (or derivatives thereof) in which at least 95% of the particles have diameters between 0.1 and 15 micrornetres. Preferred binders include Carboset 525 (methylmethacrylate/ethyl acrylate/-acrylic acid), Blendex 491, Lucite 47 KNL, Amphomer amphoteric pentapolymer (tert-octyl-acrylamide/methyl methacrylate/-hydroxypropyl-methacrylate/ tertbutylaminoethyl methacrylate/acrylic acid) acrylic binder, and PVP K-90 (polyvinylpyrrolidone). Examples of preferred monomers include acrylate, diacrylate, and triacrylate monomers, e.g., pentaerythritol triacrylate and trimethylol propane triacrylate, which may be used alone or in combination with each other. Preferred initiators are free radical generating addition polymerization initiators activatable by actinic light, e.g., benzophenone, Michler's ketone, diethyl hydroxylamine, and 3-mercapto-1,2,4-triazole.

A series of vias and micropores is formed in layer 10 using the methods described in Lake et al., U.S. Patent No. 4,666,818 entitled "Method of Patterning Resist", assigned to the assignee of the present application. According to these imaging methods, a thin, unexposed, undeveloped strip base silver or other photoimageable film (not shown) is placed over layer 10. This film and layer 10 are either sensitive to different energy spectra or show differential sensitivity to a single spectrum such that exposure of one does not affect the other. The film is then exposed using a white light x-y photoplotter driven by a computer aided design (CAD) system to create a pattern of vias for ground pick-up (the diameter of each via being approximately (0.005 inch) 130 micrometres) and an entire field of small dots for creating micropores. The actual dot pattern (and thus the micropore pattern) is selected based upon the minimum feature size to be anchored. For lines of 25 micrometres or greater, the diameter of each dot is between 5 and 30 micrometres and the dots are regularly spaced on approximately 12-60 micrometre centres. The exposed film is then developed to expose areas of layer 10 according to the above-described pattern. These areas are then exposed to ultraviolet (U.V.) light (approximately 150 millijoules/cm² at 365 nm). Following U.V. exposure, the film is peeled off and layer 10 is spray developed in a 1% sodium carbonate monohydrate solution at 40°C or a 0.75% monoethanolamine solution at 30°C for about 1 minute, water rinsed, and dried.

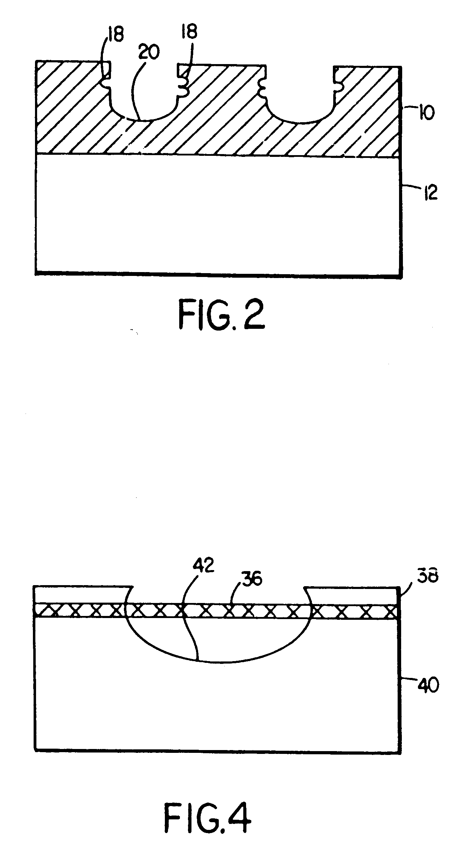

The resulting layer has a series of completely washed out via holes 14 extending down to copper ground plane support 12. It also exhibits a series of micropores 16 corresponding to areas of layer 10 exposed through the dots in the film. Each micropore is washed out to a depth of about 5-6 micrometres. Within each micropore, there exists a series of secondary micropores 18 (Fig. 2) formed when unreacted photopolymer washes out and filler particles remain in the walls of the micropore during development; the resulting "micropore within a micropore" structure is referred to as a fractal micropore. The micropore structure is also a result of light scattering during exposure. The top and inner surfaces of these micropores have a fine, matte surface for anchoring catalytic plating seeds and plated metal to layer 12.

Following development, layer 10 is exposed to U.V. at 0.5 joules/cm² and then baked at 150°C (300°F) for 1 hour followed by a second U.V. exposure at 4-5 joules/cm². It has been found that this cure process retains micropore integrity more effectively than a full U.V. cure followed by baking (which causes embrittlement) or baking prior to any U.V. exposure (which causes the resist to flow and fill the micropores). The composite structure formed by layers 10 and 12 is then immersed in a series of conventional cleaning and catalyst seeding solutions, rinsed, and dried to deposit catalytic seeds 20 for plating in the micropores.

Next, circuit layer 22 is created by hot roller laminating a layer of a moderately hydrophobic photoprocessable dry film. The preferred material is disclosed in Gervay, European Patent Application No. 87117547.7 published June 15, 1988 as EP-A-0 270 945 and consists of a monomer which is a half acryloyl ester of bisphenol A epoxy monomer, a polymerization initiator activatable by actinic radiation, and at least one preformed elastomeric polymeric binder that is substantially free of acidic groups (e.g., the number of acidic groups is sufficiently low such that the composition can withstand contact for 24 hours to a liquid at a pH of 12 maintained at a temperature of 70°C; an example of such a liquid is an electroless plating bath liquid composition described on page 7-6 of "Printed Circuits Handbook" Second Edition, ed. by Clyde F. Coombs, Jr., McGraw-Hill Book Co., 1979). It may also include an acrylated urethane, as well as dyes, pigments, fillers, and thermal polymerization inhibitors. It has a wetting tension of less than 40 dynes/cm (e.g., between 35-40 dynes/cm).

As disclosed in Gervay, preferred monomers have the formula 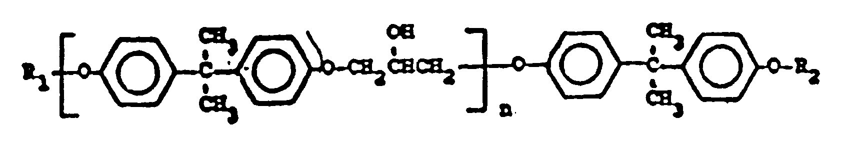
where
R₁ is 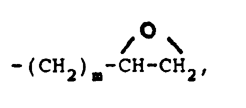
R₂ is 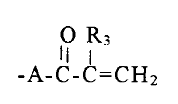
R₃ is H or an alkyl group having between 1 and 10 carbon atoms, inclusive,
A is [-(CH₂)_{q}-O)-]ᵣ or 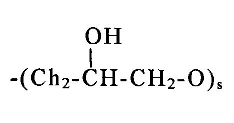
or
-A- represents a linkage between O and 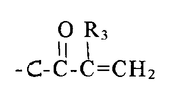
and
m, q, r, and s, independently, are integers from 1 to 10 and n is zero or an integer from 1 to 5.

Preferred binders include the elastomers described on page 232 of "Hackh's Chemical Dictionary" Fourth Edition, ed. by J. Grant, McGraw-Hill Book Co. 1972. The binders are water-insoluble, e.g., they will not dissolve in water at room temperature during 4 hours. Examples of preferred binders include methylmethacrylate/butadiene/ styrene terpolymer (e.g., Acryloid (registered trade mark) BTA-IIIs and BTA-IIIN2 commercially available from Rohm and Haas). Preferred initiators are free radical generating addition polymerization initiators activatable by actinic light, e.g., benzophenone, Michler's ketone, diethyl hydroxylamine, and 3-mercapto-1,2,4-triazole. Preferred urethanes include conventional, commercially available products such as CMD-6700, Chempol-19-4827 (Chempol: registered trade mark), andGafguard-238 (Gafguard: registered trade mark) present in an amount of 0 to 30 parts by weight.

The thickness of layer 22 is about 30 micrometres (0.0012 inch), Layer 22 is overlaid with a mask having the desired circuit and ground pick-up pattern, exposed to approximately 250 millijoules/cm² of U.V. light through the mask, and developed in 1,1,1 - trichloroethane for about 1 minute at 25°C. Following development, the circuit pattern washes out completely down to the seeded microporous layer. Next, layer 22 is baked at 150°C (300°F) for circuit pattern washes out completely down to the seeded microporous layer. Next, layer 22 is baked at 150°C (300°F) for 30 minutes, followed by flood exposure to U.V. light (2.5 joule/cm² at 365 nm) to fully cure it.

Following cure, the prepared substrate is chemically cleaned and then strike plated in a conventional electroless copper plating bath of the type commonly used for depositing copper in plated through holes. After about 1.0-2.0 micrometres (40-80 microiches) of copper have been deposited on microporous layer 10 and in the vias, the substrate is removed from the bath and transferred to a full build, high quality electroless copper plating bath of the type commonly used for fully additive plating of printed circuit boards. When the resulting electroless copper deposit 24 has plated flush to the surface of circuit layer 22, the substrate is removed from the plating bath. Vias from the ground plane layer 12 are formed and connected to circuit layer 22, as defined by the circuit pattern.

The above-described process is repeated as many times as necessary to create a printed wiring board having the desired number of circuit and via layers. The second circuit layer will interconnect to the first circuit layer through vias washed out of the microporous Vacrel layer down to copper metal sites on the first circuit layer according to the circuit pattern.

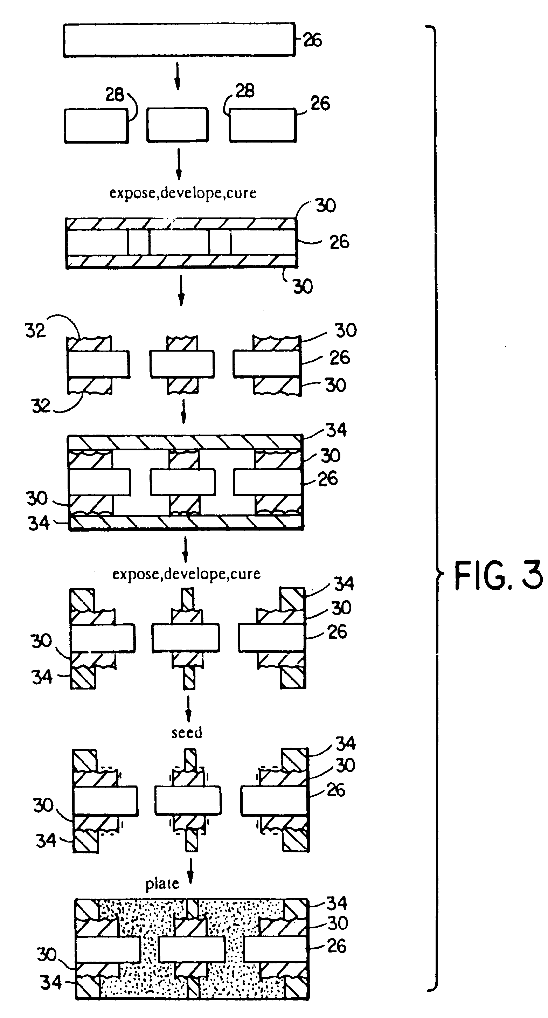

Fig. 3 illustrates the preparation of a multilayered printed wiring board using selective seeding. In this process, the catalyst seeds are added separately, rather than forming an integral part of the insulating substrate. An advantage of selective seeding is improved retention of the substrate's insulating properties upon exposure to conditions of high temperature and humidity because conductive anodic filamentation is minimized.

Referring to Fig. 3, a 0.76 micrometre (0.030 inch) glass-epoxy unclad type FR-4 substrate 26 is drilled for plated through hole interconnects 28. The drilled holes have diameters between 0.18 and 0.38 micrometres (0.007 and 0.015 inch). Substrate 26 is then cleaned, surface-prepped, and hot roller laminated on both sides with a photopolymer 30 having the composition disclosed in Tecle et al. described earlier for the mass seeding case (each layer being about 38 micrometres (0.0015 inch) thick).

Next, each photopolymer layer is overlaid with a thin silver or other photo-imageable film (not shown) as described above for the mass seeding process and the film exposed with the CAD-driven photoplotter and then developed to create a pad pattern identical to the drilled hole pattern and an entire field of small dots, each about 5 micrometres (0.0002 inch) in diameter spaced on approximately 12 micrometres (0.0005 inch) centres. The photopolymer layers are then exposed through the films to U.V. light (about 150 millijoules/cm² at a wavelength of 365 nm). Following removal of the films, the photopolymer layers are spray-developed in a 1% sodium carbonate monohydrate solution at 40°C or 0.75% monoethanolamine solution at 30°C for about one minute, rinsed with water, and dried. The resulting microporous surfaces have completely washed out via holes superimposed over the drilled holes in the substrate with the 5-30 micrometre diameter micropores 32 washed out to a depth of about 5-6 micrometres. The top and inner surfaces of the washed out micropores have a fine matte surface because these micropores are fractal micropores, as described above for the mass seeded process. The photopolymer layers are then exposed to U.V. at 0.5 joules/cm², baked at 150°C (300°F) for 1 hour, and then exposed to U.V. at 4-5 joules/cm².

The next step is to hot roller laminate each photopolymer layer with a 0.0012 inch thick layer 34 of the moderately hydrophobic photopolymer disclosed in Gervay and described earlier for the mass seeding case. These layers are then overlaid with masks having the desired circuit and via pickup patterns for each side, exposed to about 250 millijoules/cm² of U.V. light at 365 nm through the masks, and spray developed in 1,1,1-trichloroethane for about one minute at 25°C. Upon development, the desired circuit and via pickup patterns wash out completely down to the microporous surfaces. The substrate is then baked at 150°C (300°F) for 30 minutes followed by flood exposure to U.V. light (2.5 joules/cm² at 365 nm) on both sides.

Following the U.V. flood exposure, the substrate is immersed in a series of cleaning and catalysing solutions to deposit catalytic seeds for initiating metal plating in the micropores. Catalyst is selectively deposited in the micropores due to the hydrophilic nature of the via layer (to which the seeding solution is attracted) and the hydrophobic nature of the circuit layer (which repels the seeding solution). The selectively seeded substrate is then rinsed and immersed in an electroless copper strike bath of the type commonly used for copper deposition in plated through holes. After approximately 1.0-2.0 micrometres (40-80 micro-inches) of copper is plated in the through holes and exposed microporous surfaces, the substrate is removed and transferred to a high quality, full build electroless copper plating bath of the type commonly used for fully additive plating of printed circuit boards. The substrate is removed when the copper is plated flush to the surfaces of the moderately hydrophobic photopolymer.

The above-described process is repeated as many times as necessary to create a printed wiring board having the desired number of circuit and via layers. The outer circuit layers will interconnect to the inner circuit layers through vias washed out of the microporous Vacrel layers according to the circuit pattern.

Other embodiments are within the following claims.

For example, referring to Fig. 4, a finely woven cloth 36 (e.g., made of fiberglass) may be inserted between two layers of photopolymer (e.g., the moderately hydrophilic photopolymer of Tecle et al.) 38, 40. During processing, the weave is uncovered, thereby providing discrete reinforcement and a uniform number of locking bond sites for anchoring catalyst seeds to ensure uniform adhesion of metal plating no matter where holes are photoformed and filled with metal. The weave also helps control thermal expansion, thus making the board more failure resistant. Preferably, the weave is made of a bondable material having a refractive index matching that of the photopolymer to minimize bloom and scattering. The top photopolymer layer 38 preferably is thinner than the diameter of the micropore 42 formed upon U.V. exposure and development so that the pores will fully wash out when processed. This ensures that the cross weave bonding sites are properly exposed for plating.

The surface of the woven fabric can also be pre-treated with a reducing agent, e.g., palladium chloride or colloidal palladium solutions, prior to insertion between the photopolymer layers. This would auto-catalyze the plating process and ensure an excellent bond between the plated metal and the photopolymer layer.

Instead of using mass seeding or selective seeding techniques, the filler particles of the microporous photoprocessable material can be coated with catalyst during initial fabrication of the photoprocessable material prior to micropore formation.

Micropores and vias can be formed in the photoprocessable material by exposing the material through a mask having a pattern of vias and holes for forming the micropores, rather than using the CAD-directed photoplotter in combination with the thin silver film. Similarly, the circuit layer can be imaged using the CAD-directed photoplotter in combination with the thin silver film, rather than a mask.

Circuit components such as inductors can be prepared from the microporous material using the methods described in Williams, U.S. Patent No. 4,873,757 entitled "Multilayer Electrical Coil" which is assigned to the same assignee as the present application.

Adhesion of plated metal to the via layer (which may or may not be microporous) can also be promoted by treating the surface of the layer with a reactive coupling agent prior to final cure, e.g., by using the agent as the developing solution or by immersing the via layer in a water solution of the agent after development, followed by a rinse. The subsequent U.V. and thermal cure chemically bonds the agent to the surface, where it can then act to promote adhesion of subsequently plated metal. The coupling agent may also act as a catalyst for metal plating at the same time. Examples of suitable coupling agents include organotitanates (e.g., titanium triethanolamine and diethanolamine commercially available from DuPont as Tyzor TE and Tyzor DEA (Tyzor: trade mark), respectively), organozirconates (e.g., zirconium ethylene diamine commercially available from DuPont as Tyzor 212), and organosilanes (e.g., methacryloxypropyltrimethoxysilane and aminopropyltriethoxysilane, both of which are commercially available from Petrarch Chemicals as Petrarch M8550 and AP750, respectively).

## Claims

1. A printed wiring board comprising a circuit layer (22,34) made of a first material and a via layer (10,30,38,40) adjacent the circuit layer and made of a second material different from the first material,
characterised in that the via layer (10,30,38,40) is made of a cured microporous photopolymer.

2. A printed wiring board according to claim 1,
characterised in that the photopolymer is moderately hydrophilic.

3. A printed wiring board according to claim 2,
characterised in that the wetting tension of the hydrophilic photopolymer is at least 52 dynes/cm.

4. A printed wiring board according to claim 1,
characterised in that the micropores (16,32,42) of the photopolymer are fractal micropores.

5. A printed wiring board according to claim 1,
characterised in that the photopolymer comprises the polymerized product of an ethylenically unsaturated monomer, a polymerization initiator activatable by actinic radiation, at least one preformed, water-soluble, polymeric binder, and a particulate inorganic filler transparent to actinic radiation.

6. A printed wiring board according to claim 5,
characterised in that the filler is chemically bonded to the binder.

7. A printed wiring board according to claim 1,
characterised in that the via layer (38,40) comprises two layers of a cured microporous photopolymer separated by a layer of woven fabric (36).

8. A printed wiring board according to claim 7,
characterised in that the woven fabric (36) comprises a material capable of bonding to the photopolymer and having a refractive index that substantially matches the refractive index of the photopolymer.

9. A printed wiring board according to claim 7,
characterised in that the thickness of the uppermost layer (10,30,38,40) of the photopolymer is less than the diameter of the micropores (16,32,42) in the photopolymer.

10. A printed wiring board according to claim 7,
characterised in that the microporous photopolymer comprises the polymerized product of an ethylenically unsaturated monomer, a polymerization initiator activatable by actinic radiation, at least one preformed, water-soluble, polymeric binder, and a particulate inorganic filler transparent to actinic radiation.

11. A printed wiring board according to claim 11,
characterised in that the filler is chemically bonded to the binder.

12. A printed wiring board according to claim 1,
characterised in that the circuit layer (22,34) comprises a cured moderately hydrophobic photopolymer.

13. A printed wiring board according to claim 12,
characterised in that the wetting tension of the hydrophobic photopolymer is less than 40 dynes/cm.

14. A printed wiring board according to claim 12,
characterised in that the hydrophobic photopolymer comprises the polymerized product of a monomer which is a half acryloyl ester of bisphenol A epoxy monomer, a polymerization initiator activatable by actinic radiation, and at least one preformed elastomeric polymeric binder that is substantially free of acidic groups.

15. A printed wiring board according to claim 14,
characterised in that the hydrophobic photopolymer further comprises an acrylated urethane.

16. A process for preparing a printed wiring board comprising the steps of
forming a microporous via layer (10,30,38,40) from a photoprocessable photopolymer by creating micropores (16,32,42) in the photoprocessable photopolymer;
forming a circuit layer (22,34) on the via layer (10,30,38,40); and
contacting the via and circuit layers with a metal plating solution, thereby depositing metal on the portions of the via layer (10,30,38,40), excluding the circuit layer (22, 34), exposed to the plating solution.

17. A process according to claim 16,
characterised in that the via layer (10,30,38,40) is treated with a reactive coupling agent to chemically bond the agent to the surface of the via layer (10,30, 38,40).

18. A process according to claim 17,
characterised in that the coupling agent comprises an organotitanate, organozirconate, organosilane, or a combination thereof.

19. A process according to claim 17,
characterised in that the coupling agent is capable of catalyzing the deposition of metal on the exposed portions of the via layer (10,30,38,40).

20. A process according to claim 16,
characterised in that the via layer (10,30,38,40) comprises a moderately hydrophilic photoprocessable material and the circuit layer (22,34) comprises a moderately hydrophobic photoprocessable material.

21. A process according to claim 20,
characterised in that the wetting tension of the hydrophilic photoprocessable material is at least 52 dynes/cm.

22. A process according to claim 20,
characterised in that the wetting tension of the hydrophobic photoprocessable material is less than 40 dynes/cm.

23. A process according to claim 16,
characterised in that the photoprocessable material from which the microporous via layer (10,30,38,40) is formed comprises an ethylenically unsaturated monomer, a polymerization initiator activatable by actinic radiation, at least one preformed, water-soluble, polymeric binder, and a particulate inorganic filler transparent to actinic radiation.

24. A process according to claim 23,
characterised in that the filler is chemically bonded to the binder.

25. A process according to claim 23,
characterised in that the filler particles are coated with a catalyst.

26. A process according to claim 16,
characterised in that the circuit layer (22,34) comprises the polymerized product of a monomer which is a half acryloyl ester of bisphenol A epoxy monomer, a polymerization initiator activatable by actinic radiation, and at least one preformed elastomeric polymeric binder that is substantially free of acidic groups.

27. A process according to claim 16,
characterised in that the circuit layer (22,34) comprises the polymerized product of a monomer which is a half acryloyl ester of bisphenol A epoxy monomer, a polymerization initiator activatable by actinic radiation, and at least one preformed elastomeric polymeric binder that is substantially free of acidic groups; and the photoprocessable material from which the microporous via layer (10,30,38,40) is formed comprises an ethylenically unsaturated monomer, a polymerization initiator activatable by actinic radiation, at least one preformed, water-soluble, polymeric binder, and a particulate inorganic filler transparent to actinic radiation.

28. A process according to claim 27,
characterised in that in the photoprocessable layer from which the microporous via layer (10,30,38,40) is formed, the filler is chemically bonded to the binder.

29. A process according to claim 27,
characterised in that the circuit layer (22,34) further comprises an acrylated urethane.

30. A process according to claim 16,
characterised in that the via layer (10,30,38,40) is mass-seeded with catalyst particles prior to formation of the circuit layer (22,34).

31. A process according to claim 16,
characterised in that the via layer (10,30,38,40) is selectively seeded with catalyst particles subsequent to formation of the circuit layer (22,34).

32. A process according to claim 16,
characterised in that the micropores (16,32,42) are fractal micropores.

33. A process according to claim 16,
characterised in that the via layer (10,30,38,40) comprises two layers of a microporous photoprocessabie material separated by a layer of woven fabric (36).

34. A process according to claim 33,
characterised in that the woven fabric (36) comprises a material capable of bonding to the photoprocessable material and having a refractive index that substantially matches the refractive index of the photoprocessable material.

35. A process according to claim 33,
characterised in that the thickness of the uppermost layer of the photoprocessable material is less than the diameter of the micropores (16,32,42) formed in the said material.

36. A process according to claim 16,
characterised in that the micropores (16,32,42) are formed in the via layer (10,30,38,40) by:
overlaying the photoprocessable material with a mask having a plurality of dots, the diameter of the dots being selected to create micropores (16,32,42) having a predetermined diameter;
exposing said photoprocessable material through the mask to a source of radiation; and
developing the exposed areas of the photoprocessable material to create the micropores (16,32,42).

37. A process according to claim 36,
characterised in that the dots have diameters ranging from 5 to 30 microns and centers ranging from 12 to 60 microns.

38. A process according to claim 36,
characterised in that the mask further comprises a via pattern whereupon exposure and development simultaneously create vias and micropores (16,32,42) in the photoprocessable material.

39. A process according to claim 16,
characterised in that micropores (16,32,42) are formed in the via layer (10,30,38,40) by:
preparing a digital representation of a pattern comprising a plurality of dots, the diameter of the dots being selected to create micropores (16, 32,42) having a predetermined diameter;
applying a layer of unexposed, undeveloped photographic imaging film to the photoprocessable material that is sensitive to a different spectrum of energy from the photoprocessable material or is differentially sensitive to the same spectrum of energy;
selectively exposing the film with an automatic photoplotter controlled by the digital representation to activate the film without affecting the underlying layer of photoprocessable material;
developing the film;
exposing the photoprocessable material through the image developed in the film as an in situ mask; and
developing the exposed areas of the photoprocessable material to create the micropores (16,32,42).

40. A process according to claim 39,
characterised in that the dots have diameters ranging from 5 to 30 microns and centers ranging from 12 to 60 microns.

41. A process according to claim 39,
characterised in that the pattern further comprises a via pattern whereupon exposure and development simultaneously create vias and micropores (16,32,42) in the photoprocessable material.

## Patentansprüche

1. Schaltungsplatine mit einer Schaltungsschicht (22, 34) aus einem ersten Material und einer an die Schaltungsschicht angrenzenden Durchstiegsschicht (10, 30, 38, 40) aus einem von dem ersten unterschiedlichen zweiten Material, **dadurch gekennzeichnet,** daß die Durchstiegsschicht (10, 30, 38, 40) aus einem gehärteten mikroporösen Photopolymerisat hergestellt ist.

2. Schaltungsplatine nach Anspruch 1, **dadurch gekennzeichnet,** daß das Photopolymerisat mäßig hydrophil ist.

3. Schaltungsplatine nach Anspruch 2, **dadurch gekennzeichnet,** daß die Benetzungsspannung des hydrophilen Photopolymerisats mindestens 52 dyn/cm beträgt.

4. Schaltungsplatine nach Anspruch 1, **dadurch gekennzeichnet,** daß die Mikroporen (16, 32, 42) des Photopolymerisats fraktale Mikroporen sind.

5. Schaltungsplatine nach Anspruch 1, **dadurch gekennzeichnet,** daß das Photopolymerisat das polymerisierte Produkt eines ethylenisch ungesättigten Monomeren, eines durch aktinische Strahlung aktivierbaren Polymerisationsinitiators, mindestens eines vorgeformten wasserlöslichen polymeren Bindemittels sowie eines für aktinische Strahlung transparenten anorganischen Füllstoffs in Teilchenform aufweist.

6. Schaltungsplatine nach Anspruch 5, **dadurch gekennzeichnet,** daß der Füllstoff mit dem Bindemittel chemisch gebunden ist.

7. Schaltungsplatine nach Anspruch 1, **dadurch gekennzeichnet,** daß die Durchstiegsschicht (38, 40) zwei Schichten eines gehärteten mikroporösen Photopolymerisats aufweist, die von einer Schicht eines Gewebes (36) getrennt sind.

8. Schaltungsplatine nach Anspruch 7, **dadurch gekennzeichnet**, daß das Gewebe (36) ein mit dem Photopolymerisat bindungsfähiges Material aufweist, dessen Brechungsindex dem des Photopolymerisats im wesentlichen angepaßt ist.

9. Schaltungsplatine nach Anspruch 7, **dadurch gekennzeichnet,** daß die Dicke der obersten Schicht (10, 30, 38, 40) des Photopolymerisats kleiner ist als der Durchmesser der Mikroporen (16, 32, 42) im Photopolymerisat.

10. Schaltungsplatine nach Anspruch 7, **dadurch gekennzeichnet,** daß das mikroporöse Photopolymerisat das polymerisierte Produkt eines ethylenisch ungesättigten Monomeren, eines durch aktinische Strahlung aktivierbaren Polymerisationsinitiators, mindestens eines vorgeformten wasserlöslichen polymeren Bindemittels und eines für aktinische Strahlung transparenten anorganischen Füllstoffs in Teilchenform ist.

11. Schaltungsplatine nach Anspruch 11, **dadurch gekennzeichnet,** daß der Füllstoff mit dem Bindemittel chemisch gebunden ist.

12. Schaltungsplatine nach Anspruch 1, **dadurch gekennzeichnet,** daß die Schaltungsschicht (22, 34) ein gehärtetes, mäßig hydrophobes Photopolymerisat aufweist.

13. Schaltungsplatine nach Anspruch 12, **dadurch gekennzeichnet,** daß die Benetzungsspannung des hydrophoben Photopolymerisats kleiner als 40 dyn/cm ist.

14. Schaltungsplatine nach Anspruch 12, **dadurch gekennzeichnet,** daß das hydrophobe Photopolymerisat das polymerisierte Produkt eines Monomers, bei dem es sich um einen Halbacrylolyester eine Bisphenol-A-Epoxy-Monomeren handelt, eines durch aktinische Strahlung aktivierbaren Polymerisationsinitiators und mindestens eines von sauren Gruppen im wesentlichen freien, vorgeformten elastomeren polymeren Bindemittels ist.

15. Schaltungsplatine nach Anspruch 14, **dadurch gekennzeichnet,** daß das hydrophobe Photopolymerisat weiterhin ein acryliertes Urethan aufweist.

16. Verfahren zur Herstellung einer Schaltungsplatine, bei dem man
aus einem mit Licht verarbeitbaren Photopolymerisat eine mikroporöse Durchstiegsschicht (10, 30, 38, 40) herstellt, indem man im Photopolymerisat Mikroporen (16, 32, 42) erzeugt,
auf der Durchstiegsschicht (10, 30, 38, 40) eine Schaltungsschicht (22, 34) ausbildet und
die Durchstiegss- und die Schaltungsschicht einer Metallisierungslösung aussetzt und dadurch auf den der Metallisierungslösung ausgesetzten Teilen der Durchstiegsschicht (10, 30, 38, 40) ausschließlich der Schaltungsschicht (22, 34) Metall ablagert.

17. Verfahren nach Anspruch 16, **dadurch gekennzeichnet**, daß die Durchstiegsschicht (10, 30, 38, 40) mit einem reaktionsfähigen Kopplungsmittel behandelt wird, um das Mittel mit der Oberfläche der Durchstiegsschicht (10, 30, 38, 40) zu verbinden.

18. Verfahren nach Anspruch 16, **dadurch gekennzeichnet**, daß das Kopplungsmittel ein Organotitanat, ein Organozirconat, ein Organosilan oder eine Kombination aus diesen aufweist.

19. Verfahren nach Anspruch 17, **dadurch gekennzeichnet,** daß das Kopplungsmittel in der Lage ist, die Ablagerung von Metall auf den freiliegenden Teilen der Durchstiegsschicht (10, 30, 38, 40) zu katalyseiren.

20. Verfahren nach Anspruch 16, **dadurch gekennzeichnet,** daß die Durchstiegsschicht (10, 30, 38, 40) ein maßig hydrophiles, mit Licht verarbeitbares Material und die Schaltungsschicht (22, 34) ein mäßig hydrophobes, mit Licht verarbeitbares Material aufweisen.

21. Verfahren nach Anspruch 20, **dadurch gekennzeichnet,** daß die Benetzungsspannung des mit Licht verarbeitbaren hydrophilen Materials mindestens 52 dyn/cm beträgt.

22. Verfahren nach Anspruch 20, **dadurch gekennzeichnet,** daß die Benetzungsspannung des mit Licht verarbeitbaren hydrophoben Materials kleiner als 40 dyn/cm ist.

23. Verfahren nach Anspruch 16, **dadurch gekennzeichnet,** daß das mit Licht verarbeitbare Material, aus dem die mikroporöse Schicht (10, 30, 38, 40) hergestellt wird, ein ethylenisch ungesättigtes Monomer, einen durch aktinische Strahlung aktivierbaren Polymerisationsinitiator, mindestes ein vorgeformtes wasserlösliches polymeres Bindemittel und einen für aktinische Strahlung transparenten anorganischen Füllstoff in Teilchenform aufweist.

24. Verfahren nach Anspruch 23, **dadurch gekennzeichnet,** daß der Füllstoff mit dem Bindemittel chemisch gebunden wird.

25. Verfahren nach Anspruch 23, **dadurch gekennzeichnet,** daß die die Füllstoffteilchen mit einem Katalysator beschichtet sind.

26. Verfahren nach Anspruch 16, **dadurch gekennzeichnet,** daß die Schaltungsschicht (22, 34) das polymerisierte Produkt eines Monomers, bei dem es sich um ein Halbacrylolyester eines Bisphenol-A-Epoxy-Monomers handelt, eines durch aktinische Strahlung aktivierbaren Polymerisationsinitiators und mindestens eines von sauren Gruppen im wesentlichen freien, vorgeformten elastomeren polymeren Bindemittels ist.

27. Verfahren nach Anspruch 16, **dadurch gekennzeichnet,** daß die Schaltungsschicht (22, 34) das polymerisierte Produkt eines Monomers, bei dem es sich um eien Halbacrylolyester eines Bisphenol-A-Epoxy-Monomers handelt, eines durch aktinische Strahlung aktivierbaren Polymerisationsinitiators und mindestens eines von sauren Gruppen im wesentlichen freien, vorgeformten elastomeren polymeren Bindemittels aufweist, und daß das mit Licht verarbeitbare Material, aus dem die mikroporöse Durchstiegsschicht (10, 30, 38, 40) hergestellt ist, ein ethylenisch ungesättigtes Monomer, einen mit aktinischer Strahlung aktivierbaren Polymerisationsinitiator, mindestens ein vorgeformtes wasserlösliches polymeres Bindemittel und einen für aktinische Strahlung transparenten anorganischen Füllstoff in Teilchenform aufweist.

28. Verfahren nach Anspruch 27, **dadurch gekennzeichnet,** daß in der mit Licht verarbeitbaren Schicht, aus der die mikroporöse Durchstiegsschicht (10, 30, 38, 40) hergestellt wird, der Füllstoff chemisch an das Bindemittel gebunden ist.

29. Verfahren nach Anspruch 27, **dadurch gekennzeichnet,** daß die Schaltungsschicht (22, 34) weiterhin ein acryliertes Urethan aufweist.

30. Verfahren nach Anspruch 16, **dadurch gekennzeichnet,** daß die Durchstiegsschicht (10, 30, 38, 40) vor der Bildung der Schaltungsschicht (22, 34) mit Katalysatorteilchen massenbesät wird.

31. Verfahren nach Anspruch 16, **dadurch gekennzeichnet,** daß die Durchstiegsschicht (10, 30, 38, 40) nach der Bildung der Schaltungsschicht (22, 34) selektiv mit Katalysatorteilchen massenbesät wird.

32. Verfahren nach Anspruch 16, **dadurch gekennzeichnet**, daß die Mikroporen (16, 32, 42) fraktale Mikroporen sind.

33. Verfahren nach Anspruch 16, **dadurch gekennzeichnet**, daß die Durchstiegsschicht (10, 30, 38, 40) zwei Schichten eines mikroporösen, mit Licht verarbeitbaren Materials aufweist, die von einer Schicht eines Gewebes (36) getrennt sind.

34. Verfahren nach Anspruch 33, **dadurch gekennzeichnet,** daß das Gewebe (36) ein mit dem Photopolymerisat bindungsfähiges Material aufweist, dessen Brechungsindex dem des Photopolymerisats im wesentlichen angepaßt ist.

35. Verfahren nach Anspruch 33, **dadurch gekennzeichnet,** daß die Dicke der obersten Schicht aus dem mit Licht verarbeitbaren Material kleiner ist als der Durchmesser der in diesem Material erzeugten Mikroporen (16, 32, 42).

36. Verfahren nach Anspruch 16, **dadurch gekennzeichnet,** daß die Mikroporen (16, 32, 42) in der Durchstiegsschicht (10, 30, 38, 40) erzeugt werden, indem man
auf das mit Licht verarbeitbare Material eine Maske mit eine Vielzahl von Pünktchen auflegt, deren Durchmesser so gewählt wird, daß Mikroporen (16, 32, 42) mit einem vorbestimmten Durchmesser erzeugt werden,
das mit Licht verarbbeitbare Material durch die Maske hindurch mit aktinischer Strahlung bestrahlt, und
die bestrahlten Bereiche des mit Licht verarbeitbaren Materials entwickelt, um die Mikroporen (16, 32, 42) zu erzeugen.

37. Verfahren nach Anspruch 36, **dadurch gekennzeichnet,** daß die die Pünktchen Durchmesser im Bereich von 5 bis 30 »m und Mittelpunktsabstände im Bereich von 12 bis 60 »m haben.

38. Verfahren nach Anspruch 36, **dadurch gekennzeichnet,** daß die Maske weiterhin ein Durchstiegsmuster aufweist, wobei durch die Bestrahlung und die Entwicklung die Durchstiegslöcher und die Mikroporen (16, 32, 42) im mit Licht verarbeitbaren Material gleichzeitig erzeugt werden.

39. Verfahren nach Anspruch 16, **dadurch gekennzeichnet,** daß die Mikroporen (16, 32, 42) in der Durchstiegsschicht (10, 30, 38, 40) erzeugt werden, indem man
eine digitale Darstellung eines Musters aus einer Vielzahl von Pünktchen herstellt, deren Durchmesser so gewählt werden, daß Mikroporen (16, 32, 42) mit einem vorbestimmten Durchmesser erzeugt werden,
auf das mit Licht verarbeitbare Material eine Schicht aus einem unbestrahlten und nicht entwickelten photographischen bilderzeugenden Film aufbringt, der für ein anderes Energiespektrum als das mit Licht verarbeitbare Material oder für das gleiche Energiespektrum wie dieses unterschiedlich empfindlich ist,
den Film mit einem automatischen, von der digitalen Darstellung gesteuerten Photoplotter selektiv bestrahlt, um den Film zu aktivieren, ohne die darunter befindliche Schicht aus dem mit Licht verarbeitbaren Material zu beeinflussen,
den Film entwickelt,
das mit Licht verarbeitbare Material durch das im Film entwickelte Bild als In-situ-Maske hindurch bestrahlt und
die bestrahlten Bereiche des mit Licht verarbeitbaren Materials entwickelt, um die Mikroporen (16, 32, 42) zu erzeugen.

40. Verfahren nach Anspruch 39, **dadurch gekennzeichnet,** daß die die Pünktchen Durchmesser im Bereich von 5 bis 30 »m und Mittelpunktsabstände im Bereich von 12 bis 60 »m haben.

41. Verfahren nach Anspruch 39, **dadurch gekennzeichnet,** daß das Muster weiterhin ein Durchstiegsmuster aufweist, wobei durch die Bestrahlung und die Entwicklung die Durchstiegslöcher und die Mikroporen (16, 32, 42) im mit Licht verarbeitbaren Material gleichzeitig erzeugt werden.

## Revendications

1. Carte de câblage imprimée comprenant une couche de circuit (22, 24) fabriquée à partir d'un premier matériau et une couche de transit (10, 30, 38, 40) adjacente à la couche de circuit et fabriquée à partir d'un second matériau différent du premier, caractérisée en ce que la couche de transit (10, 30, 38, 40) est fabriquée à partir d'un photopolymère microporeux endurci.

2. Carte de câblage imprimée selon la revendication 1, caractérisée en ce que le photopolymère est moyennement hydrophile.

3. Carte de câblage imprimée selon la revendication 2 caractérisée en ce que la tension de mouillage du photopolymère hydrophile est d'au moins 52 dynes/cm.

4. Carte de câblage imprimée selon la revendication 1, caractérisée en ce que les micropores (16, 32, 42) du photopolymère sont des micropores de fracture.

5. Carte de câblage imprimée selon la revendication 1, caractérisée en ce que le photopolymère comprend le produit de polymérisation d'un monomère à liaisons éthyléniques insaturées, un initiateur de la polymérisation activable par les rayons actiniques, au moins un liant polymère, soluble dans l'eau, préalablement formé, et une charge inorganique particulaire transparente aux rayons actiniques.

6. Carte de câblage imprimée selon la revendication 5, caractérisée en ce que la charge est liée par voie chimique au liant.

7. Carte de câblage imprimée selon la revendication 1, caractérisée en ce que la couche de transit (38, 40) comprend deux couches d'un photopolymère microporeux endurci séparées l'une de l'autre par une couche d'étoffe tissée (36).

8. Carte de câblage imprimée selon la revendication 7, caractérisée en ce que l'étoffe tissée (36) comprend un matériau capable de se lier au photopolymère et ayant un index de réfraction essentiellement équivalent à l'index de réfraction du photopolymère.

9. Carte de câblage imprimée selon la revendication 7, caractérisée en ce que l'épaisseur de la couche la plus superficielle (10, 30, 38, 40) du photopolymère est inférieure au diamètre des micropores (16, 32, 42) du photopolymère.

10. Carte de câblage imprimée selon la revendication 7, caractérisée en ce que le photopolymère microporeux comprend un produit de polymérisation d'un monomère à liaisons éthyléniques insaturées, un initiateur de la polymérisation activable par les rayons actiniques, au moins un liant polymère, soluble dans l'eau, préalablement formé, et une charge inorganique particulaire transparente aux rayons actiniques.

11. Carte de câblage imprimée selon la revendication 11, caractérisée en ce que la charge est liée par voie chimique au liant.

12. Carte de câblage imprimée selon la revendication 1, caractérisée en ce que la couche de circuit imprimée (22, 34) comprend un photopolymère endurci moyennement hydrophobe.

13. Carte de câblage imprimée selon la revendication 12, caractérisée en ce que la tension de mouillage du photopolymère hydrophobe est inférieure à 40 dynes/cm.

14. Carte de câblage imprimée selon la revendication 12, caractérisée en ce que le photopolymère hydrophobe comprend un produit de polymérisation d'un monomère qui est un semi-ester acryloylique du bisphénol A époxy, un initiateur de la polymérisation activable par les rayons actiniques, et au moins un liant polymère élastomère préalablement formé qui est essentiellement exempt de groupes acides.

15. Carte de câblage imprimée selon la revendication 14, caractérisée en ce que le photopolymère hydrophobe comprend en outre une uréthanne modifiée par l'acrylate.

16. Procédé de préparation d'une carte de câblage imprimée comprenant les étapes
de formation d'une couche de transit microporeuse (10, 30, 38, 40) à partir d'un photopolymère pouvant être mis en oeuvre sous l'effet de la lumière en générant des micropores (16, 32, 42) dans le photopolymère pouvant être mis en oeuvre sous l'effet de la lumière;
de formation d'une couche de circuit (22, 34) sur la couche de transit (10, 30, 38, 40); et
de mise en contact des couches de transit et de circuit avec une solution de plaquage métallique de manière à déposer du métal sur les parties de la couche de transit (10, 30, 38, 40) à l'exclusion de la couche de circuit (22, 34), exposée à la solution de plaquage.

17. Procédé selon la revendication 16, caractérisé en ce que la couche de transit (10, 30, 38, 40) est traitée avec un agent de couplage réactif en vue de lier l'agent par voie chimique à la surface de la couche de transit (10, 30, 38, 40).

18. Procédé selon la revendication 17, caractérisé en ce que l'agent de couplage comprend un organotitanate, un organozirconate, un organosilane, ou une association de ceux-ci.

19. Procédé selon la revendication 17, caractérisé en ce que l'agent de couplage est capable de catalyser le dépôt de métal sur les parties exposées de la couche de transit (10, 30, 38, 40).

20. Procédé selon la revendication 16, caractérisé en ce que la couche de transit (10, 30, 38, 40) comprend un matériau moyennement hydrophile pouvant être mis en oeuvre sous l'effet de la lumière et en ce que la couche de circuit (22, 34) comprend un matériau moyennement hydrophobe pouvant être mis en oeuvre sous l'effet de la lumière.

21. Procédé selon la revendication 20, caractérisé en ce que la tension de mouillage du matériau hydrophile pouvant être mis en oeuvre sous l'effet de la lumière est d'au moins 52 dynes/cm.

22. Procédé selon la revendication 20, caractérisé en ce que la tension de mouillage du matériau hydrophobe pouvant être mis en oeuvre sous l'effet de la lumière est inférieure à 40 dynes/cm.

23. Procédé selon la revendication 16, caractérisé en ce que le matériau pouvant être mis en oeuvre sous l'effet de la lumière et à partir duquel la couche de transit microporeuse (10, 30, 38, 40) est formée comprend un monomère à liaisons éthyléniques insaturées, un initiateur de la polymérisation activable par les rayons actiniques, au moins un liant polymère, soluble dans l'eau, préalablement formé, et une charge inorganique particulaire transparente aux rayons actiniques.

24. Procédé selon la revendication 23, caractérisé en ce que la charge est liée par voie chimique au liant.

25. Procédé selon la revendication 23, caractérisé en ce que les particules de charge sont recouvertes de catalyseur.

26. Procédé selon la revendication 16, caractérisé en ce que la couche de circuit (22, 34) comprend le produit de polymérisation d'un monomère qui est un semi-ester acryloylique du bisphénol A époxy, un initiateur de la polymérisation activable par les rayons actiniques, et au moins un liant polymère élastomère préalablement formé qui est essentiellement exempt de groupes acides.

27. Procédé selon la revendication 16, caractérisé en ce que la couche de circuit (22, 34) comprend un produit de polymérisation d'un monomère qui est un semi-ester acryloylique du bisphénol A époxy, un initiateur de la polymérisation activable par les rayons actiniques, et au moins un liant polymère élastomère préalablement formé qui est essentiellement exempt de groupes acides, et en ce que le matériau susceptible d'être mis en oeuvre sous l'effet de la lumière à partir duquel la couche de transit microporeuse (10, 30, 38, 40) est formée comprend un monomère à liaisons éthyléniques insaturées, un initiateur de la polymérisation activable par les rayons actiniques, au moins un liant polymère, soluble dans l'eau préalablement formé, et une charge inorganique particulaire transparente aux rayons actiniques.

28. Procédé selon la revendication 27, caractérisé en ce qu'à l'intérieur de la couche pouvant être mise en oeuvre sous l'effet de la lumière à partir de laquelle la couche de transit microporeuse (10, 30, 38, 40) est formée, la charge est liée par voie chimique au liant.

29. Procédé selon la revendication 27, caractérisé en ce que la couche de circuit (22, 34) comprend en outre une uréthanne modifiée par l'acrylate.

30. Procédé selon la revendication 16, caractérisé en ce que la couche de transit (10, 30, 38, 40) est ensemencée en masse avec des particules de catalyseur avant la formation de la couche circuit (22, 34).

31. Procédé selon la revendication 16, caractérisée en ce que la couche de transit (10, 30, 38, 40) est ensemencée de manière sélective avec les particules de catalyseur à la suite de la formation de la couche de circuit (22, 34).

32. Procédé selon la revendication 16, caractérisé en ce que les micropores (16, 32, 42) sont des micropores de fracture.

33. Procédé selon la revendication 16, caractérisé en ce que la couche de transit (10, 30, 38, 40) comprend deux couches d'un matériau microporeux pouvant être en mis en oeuvre sous l'effet de la lumière séparées l'une de l'autre par une étoffe tissée (36).

34. Procédé selon la revendication 33, caractérisé en ce que l'étoffe tissée (36) comprend un matériau capable de se lier au matériau pouvant être mis en oeuvre sous l'effet de la lumière et ayant un index de réfraction qui est essentiellement équivalent à l'index de réfraction du matériau pouvant être en oeuvre sous l'effet de la lumière.

35. Procédé selon la revendication 33, caractérisé en ce que l'épaisseur de la couche la plus superficielle du matériau pouvant être mis en oeuvre sous l'effet de la lumière est inférieure au diamètre des micropores (16, 32, 42) formés dans ledit matériau.

36. Procédé selon la revendication 16, caractérisé en ce que les micropores (16, 32, 42) sont formés dans la couche de transit (10, 30, 38, 40) par:
la superposition d'une couche de couverture ayant une pluralité de pastilles sur le matériau pouvant être mis en oeuvre sous l'effet de la lumière, le diamètre des pastilles étant sélectionné de manière à produire des micropores (16, 32, 42) ayant un diamètre prédéterminé;
l'exposition dudit matériau pouvant être mis en oeuvre sous l'effet de la lumière à travers la couche de couverture à une source de rayonnement; et
le développement des régions exposées sur le matériau pouvant être mis en oeuvre sous l'effet de la lumière en vue produire des micropores (13, 32, 42).

37. Procédé selon la revendication 36, caractérisé en ce que les pastilles présentent un diamètre allant de 5 à 30 »m et des centres mesurant de 12 à 60 »m.

38. Procédé selon la revendication 36, caractérisé en ce que la couche de couverture comprend en outre un motif de transit qui, à la suite d'exposition et de développement simultanés, produit des passages et des micropores (16, 32, 42) dans le matériau pouvant être mis en oeuvre sous l'effet de la lumière.

39. Procédé selon la revendication 16, caractérisé en ce les micropores (16, 32, 42) dans la couche de transit (10, 30, 38, 40) sont formés par:
la préparation d'une représentation numérique d'un motif comprenant une pluralité de pastilles, le diamètre des pastilles étant choisi de manière à produire des micropores (16, 32, 42) ayant un diamètre prédéterminé,
l'application d'une couche d'un film pour cliché photographique non développé, non exposé au matériau pouvant être mis en oeuvre sous l'effet de la lumière qui est sensible à un spectre d'énergie différent de celui du matériau pouvant être mis en oeuvre sous l'effet de la lumière ou dont le degré de sensibilité est différent pour le même spectre d'énergie;
l'exposition sélective du film à l'aide d'un appareil de restitution automatique commandé par la représentation numérique en vue d'activer le film sans altérer la couche sous-jacente de matériau pouvant être mis en oeuvre sous l'effet de la lumière;
le développement du film;
l'exposition du matériau susceptible d'être mis en oeuvre sous l'effet de la lumière à travers l'image développée sur le film à titre de couche de couverture *in situ*; et
le développement des régions exposées du matériau pouvant être en oeuvre sous l'effet de la lumière en vue de produire des micropores (13,32, 42).

40. Procédé selon la revendication 39, caractérisé en ce que les pastilles présentent un diamètre allant de 5 à 30 »m et un centre mesurant de 12 à 60 »m.

41. Procédé selon la revendication 39, caractérisé en ce que le motif comprend en outre un motif de transit qui à la suite d'exposition et de développement simultanés produit des passages et des micropores (16, 32, 42) dans le matériau pouvant être mis en oeuvre sous l'effet de la lumière.
